# EUROPEAN PATENT APPLICATION

(11) **EP 4 576 093 A1**
(43) Date of publication of application: **25.06.2025**
(21) Application number: 24212981.5
(22) Date of filing: 14.11.2024
(51) Int. Cl.: G11C 11/412

(54) **MEMORY BITCELL WITH BALANCED DIFFUSION LAYOUT**

(30) Priority: 22.12.2023 US 202318395335
(71) Applicant: INTEL Corporation, Santa Clara, CA 95054 (US)
(72) Inventor: GHOSH, Amian, Mebane, NC 27302 (US); MERCHANT, Feroze, Austin, TX 78750 (US)
(74) Representative: Viering, Jentschura & Partner mbB Patent- und Rechtsanwälte

(57) **Abstract**

Various embodiments provide apparatuses, systems, and methods for a memory bitcells with a balanced distribution of (e.g., equal numbers of) p-type transistors (e.g., p-type metal-oxide-semiconductor (PMOS)) and n-type transistors (e.g., n-type metal-oxide-semiconductor (NMOS)). For example, the memory bitcell may include an NMOS passgate transistor and a PMOS passgate transistor coupled to the bit node. The memory bitcell may further include another NMOS passgate transistor and another PMOS passgate transistor coupled to the bit bar node. Other embodiments may be described and claimed.

## Description

### Background

There are a number of long-term technology trends in embedded memory, such as static random access memory (SRAM) and/or register file (RF) memory. For example, compute dies utilize increasing amounts of embedded memory to achieve high performance and/or low power. Additionally, the area of memory circuitry has scaled poorly compared to logic circuitry over time. Furthermore, the density of memory defects has increased over time. All of these trends lead to additional circuit area being devoted to embedded memory.

### Brief Description of the Drawings

Embodiments will be readily understood by the following detailed description in conjunction with the accompanying drawings. To facilitate this description, like reference numerals designate like structural elements. Embodiments are illustrated by way of example and not by way of limitation in the figures of the accompanying drawings.
Figure 1 schematically illustrates a memory cell in accordance with various embodiments herein.
Figure 2 schematically illustrates a memory circuit that includes the memory cell of Figure 1, in accordance with various embodiments.
Figure 3 schematically illustrates another example memory cell in accordance with various embodiments.
Figure 4 schematically illustrates a dual-ported memory cell in accordance with various embodiments.
Figure 5 illustrates example experimental results of writability of the memory cell described herein compared with a legacy memory cell and logic circuit.
Figure 6 illustrates an example system configured to employ the apparatuses and methods described herein, in accordance with various embodiments.

### Detailed Description

Various embodiments herein include memory cells (also referred to as bitcells) with several improvements compared with prior techniques, such as more balanced distribution of (e.g., equal numbers of) p-type transistors (e.g., p-type metal-oxide-semiconductor (PMOS)) and n-type transistors (e.g., n-type metal-oxide-semiconductor (NMOS)). The bitcell may be implemented in embedded memory circuitry, such as static random access memory (SRAM) and/or register file circuitry. In some embodiments, the embedded memory circuitry may provide a cache memory for one or more processor cores. The bitcell may additionally or alternatively be implemented in other types and/or uses of memory circuitry.

The bitcell may include a bit node to store a logic value of a bit, and a bit bar node to store an inverse of the logic value. The bitcell may further include a first passgate transistor and a second passgate transistor with respective first source or drain terminals coupled to the bit node. The first passgate transistor may be a p-type (e.g., PMOS) transistor, and the second passgate transistor may be an n-type (e.g., NMOS) transistor. Both of the first and second passgate transistors may be turned on during a write operation to write the logic value to the bit node. For example, one of the first or second passgate transistor may have its second source or drain terminal coupled to a write bit line (wbl) and its gate terminal coupled to a write word line (wwl). The other of the first or second passgate transistor may have its second source or drain terminal coupled to a read and write bit line (rwbl) and its gate terminal coupled to a read and write word line (rwwl). The wwl and rwwl may both be asserted during the write operation (to turn both the first and second passgate transistors on), while just the rwwl may be asserted during a read operation.

In some embodiments, the bitcell may further include a third passgate transistor and a fourth passgate transistor with respective source or drain terminals coupled to the bit bar node. The third passgate transistor may be a p-type (e.g., PMOS) transistor, and the fourth passgate transistor may be an n-type (e.g., NMOS) transistor. One of the third or fourth passgate transistor may have its second source or drain terminal coupled to a write bit line bar (wblb) and its gate terminal coupled to the write word line (wwl). The other of the first or second passgate transistor may have its second source or drain terminal coupled to a read and write bit line bar (rwblb) and its gate terminal coupled to the read and write word line (rwwl). Both of the third and fourth passgate transistors may also be turned on during a write operation (responsive to the respective wwl and rwwl).

Accordingly, the bitcell may provide dual-ended and complementary write operation (e.g., to write both a logic 0 and a logic 1). The bitcell may not require a write assist, thereby improving performance and decreasing circuit area and power consumption. Furthermore, the bitcell provides improved read stability (e.g., lower minimum operating supply voltage, Vmin) compared with prior techniques. The lower Vmin may enable the bitcell to use a single power rail (e.g., single-rail SRAM), which avoids the design complexity and level-shifter overhead required by dual-rail memory bitcells. Furthermore, the lower Vmin provides lower dynamic capacitance (Cdyn) and leakage power of the memory circuitry.

In embodiments, the bitcell may further include pull-up and pull-down transistors (e.g., configured as cross-coupled inverters) to store the logic value of the bit in the bit node and the inverse of the logic value in the bit bar node. For example, the bitcell may include a first pull-up transistor coupled between the bit node and a Vcc rail and having a gate terminal coupled to the bit bar node, and a first pull-down transistor coupled between the bit node and a Vss rail and having a gate terminal coupled to the bit bar node. The bitcell may further include a second pull-up transistor coupled between the bit bar node and the Vcc rail and having a gate terminal coupled to the bit node, and a second pull-down transistor coupled between the bit bar node and the Vss rail and having a gate terminal coupled to the bit node. The Vcc rail may receive a positive supply voltage and the Vss rail may receive a negative supply voltage (e.g., ground). The first and second pull-up transistors may be PMOS transistors and the first and second pull-down transistors may be NMOS transistors.

Accordingly, the bitcell may include an equal number of NMOS and PMOS transistors. This may provide improved area efficiency in current and future process technologies, such as complementary field-effect transistor (CFET) technologies that utilize stacked devices. In embodiments, the memory circuitry may more efficiently utilize the diffusion regions, and the memory area may scale proportionally to logic area. Additionally, the height, diffusion pattern, and distribution of Nwell and Pwell regions may correspond to (e.g., be the same as) that used for logic cell layout. Accordingly, the bitcells described herein may reduce and/or eliminate the need for transition regions between bitcell segments and the peripheral read/write circuitry. This may be particularly beneficial for memory arrays having a smaller number of bits per bitline, which typically require many transition regions between the bitcell regions and peripheral regions.

Embodiments herein may further include a dual-ported bitcell with balanced number of NMOS and PMOS transistors. The dual-ported bitcell may have a same transistor configuration as the bitcell described above, but with the passgate transistors on each side of the bitcell coupled to respective ports. Having the same footprint for the single-ported and dual-ported bitcell may facilitate implementation across the memory compiler porting from one logic technology to another.

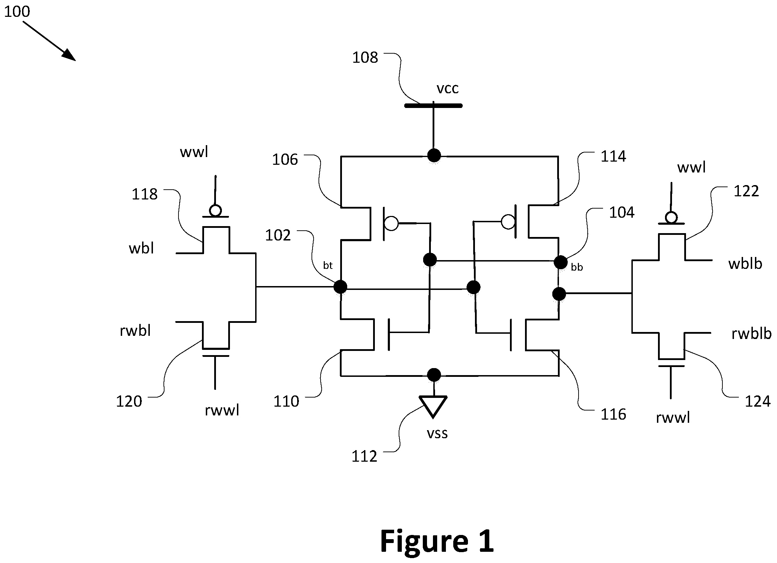

Figure 1 illustrates an example memory cell 100 (also referred to as a bitcell) in accordance with various embodiments. The memory cell 100 may be an SRAM cell, and may implement a register file in some embodiments. For example, in some embodiments, the memory cell 100 may be implemented in a memory circuitry that provides embedded memory for one or more processor cores. The memory cell 100 may additionally or alternatively be used in other implementations.

The memory cell 100 may include a bit node 102 and a bit bar node 104. The bit node 102 may store a logic value of a bit, and the bit bar node 104 may store the inverse of the logic value (e.g., corresponding to bit bar). A first pull-up transistor 106 may be coupled between the bit node 102 and a Vcc rail 108 (e.g., with a first source or drain terminal coupled to the bit node 102 and a second source or drain terminal coupled to the Vcc rail 108). A first pull-down transistor 110 may be coupled between the bit node 102 and a Vss rail 112 (e.g., with a first source or drain terminal coupled to the bit node 102 and a second source or drain terminal coupled to the Vss rail 112). A second pull-up transistor 114 may be coupled between the bit bar node 104 and the Vcc rail 108, and a second pull-down transistor 116 may be coupled between the bit bar node 104 and the Vss rail 108. The first and second pull-up transistors 106 and 114 may be PMOS transistors, and the first and second pull-down transistors 110 and 116 may be NMOS transistors.

Gate terminals of the first pull-up transistor 106 and first pull-down transistor 110 may be coupled to the bit bar node 104, while gate terminals of the second pull-up transistor 114 and second pull-down transistor 116 may be coupled to the bit node 102. Accordingly, the pull-up and pull-down transistors may form cross-coupled inverters to store the logic value of the bit at the bit node and the inverse of the logic value at the bit bar node.

The memory cell may further include a first passgate transistor 118 and a second passgate transistor 120 with respective first source or drain terminals coupled to the bit node 102. The first passgate transistor 118 may be a PMOS transistor, and the second passgate transistor 120 may be an NMOS transistor. In embodiments, the first passgate transistor 118 may have its second source or drain terminal coupled to a write bit line (wbl) and its gate terminal coupled to a write word line (wwl). The second passgate transistor 120 may have its second source or drain terminal coupled to a read and write bitline (rwbl) and its gate terminal coupled to a read and write wordline (rwwl).

In embodiments, the memory cell 100 may further include a third passgate transistor 122 and a fourth passgate transistor 124 with respective first source or drain terminals coupled to the bit bar node. The third passgate transistor 122 may be a PMOS transistor, and the fourth passgate transistor 124 may be an NMOS transistor. In embodiments, the third passgate transistor 122 may have its second source or drain terminal coupled to a write bit line bar (wblb) and its gate terminal coupled to the write word line (wwl). The fourth passgate transistor 124 may have its second source or drain terminal coupled to a read and write bitline bar (rwblb) and its gate terminal coupled to the read and write wordline (rwwl).

In some embodiments, the drive strength of the pull-down transistors 110 and 116 may be greater than the drive strength of the pull-up transistors 106 and 114. For example, the ratio of relative drive strength may be less than 2:1, such as 3:2. In some embodiments, the drive strength of the passgate transistors 118, 120, 122, and/or 124 may be substantially the same as the pull-up transistors 106 and 114 (e.g., subject to normal process variation) and less than the pull-down transistors 106 and 114. In other embodiments, the pull-up transistors and pull-down transistors of the memory bitcell described herein may have substantially the same drive strength. The memory cell 100 may have less strict and/or more equal drive strength ratios than prior techniques, as further discussed elsewhere in this disclosure.

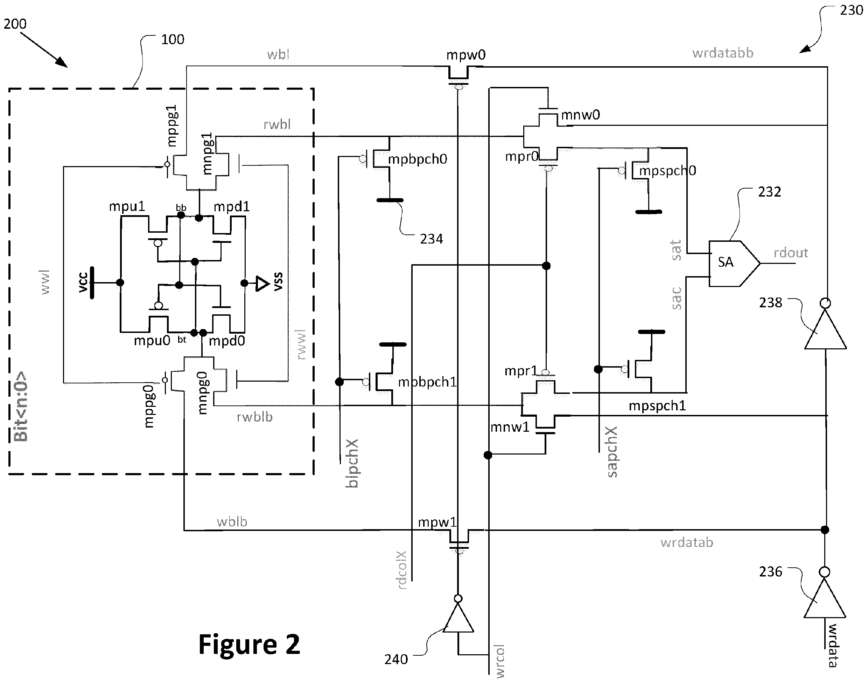

During a write operation, the wwl and rwwl are both asserted to turn on all four passgate transistors 118, 120, 122, and 124. During a read operation, the rwwl is asserted (and not the wwl) to turn on passgate transistors 120 and 124. The write and read operations are described in further detail with respect to Figure 2, which shows example read and write circuitry.

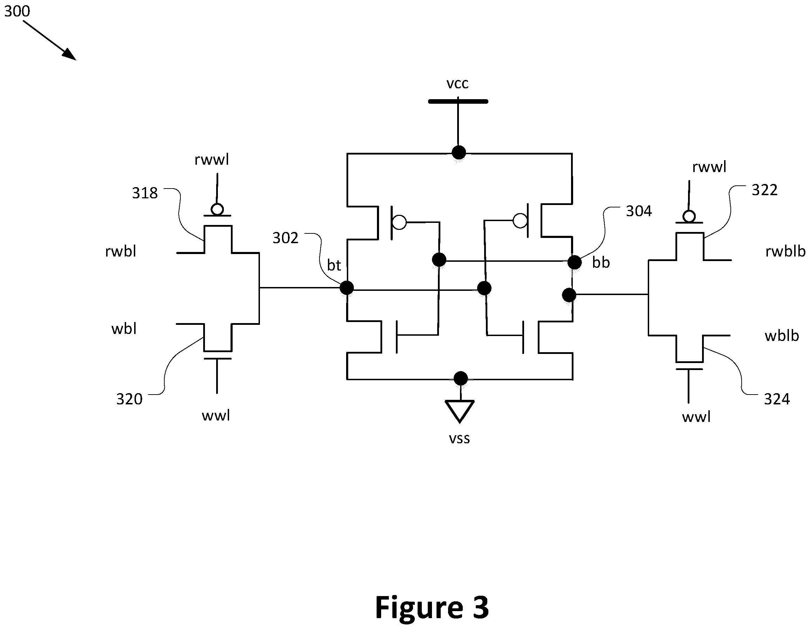

It is noted that the configuration of the NMOS and PMOS passgate transistors in the memory cell may be switched, e.g., as shown for memory cell 300 in Figure 3. In the memory cell 300, PMOS passgate transistor 318 is coupled between the bit node 302 and the rwbl and receives the rwwl at its gate terminal, NMOS passgate transistor 320 is coupled between the bit node 302 and the wbl and receives the wwl at its gate terminal. Additionally, PMOS passgate transistor 322 is coupled between the bit bar node 304 and the rwblb and receives the rwwl at its gate terminal, and NMOS passgate transistor 324 is coupled between the bit bar node 304 and the wblb and receives the wwl at its gate terminal.

Figure 2 illustrates a memory circuitry 200 that incorporates an array of memory cells 100 and read and write circuitry 230, in accordance with various embodiments. The memory circuitry 200 may include any suitable number of memory cells 100 in the array, such as 64, 128, 256, 512, etc.

In the memory cell 100 of Figure 2, the pull-up transistors may be referred to as mpu0 and mpu1, respectively, pull-down transistors may be referred to as mpd0 and mpd1, respectively, the PMOS passgate transistors may be referred to as mppg0 and mppg1, respectively, and the NMOS passgate transistors may be referred to as mnpg0 and mnpg1, respectively. The notation "mp_" may refer to PMOS devices (transistors), while the notation "mn_" may refer to NMOS devices (transistors). However, it will be apparent that the types and configuration of transistors in the memory circuitry 200 are presented as examples, and other embodiments may include different types and/or configuration of transistors.

A read path of the read and write circuitry 230 may include a first read column select device mpr0 coupled between the rwbl and a first input (sat) of a sense amplifier 232, and a second read column select device mpr1 coupled between the rwblb and a second input (sac) of the sense amplifier 232. Gate terminals of the read column select devices mpr0 and mpr1 may receive a read column select signal, rdcolx.

The read and write circuitry 230 may further include bitline precharge devices mpbpch0 and mpbpch1 may be coupled between a supply rail 234 (with may correspond to Vcc) and the respective rwbl and rwblb. The gate terminals of the bitline precharge devices mpbpch0 and mpbpch1 may receive a bit line precharge signal, blpchx. The read and write circuitry 230 may further include sense amplifier precharge devices mpspch0 and mpspch1 coupled between the supply rail 234 and the respective inputs of the sense amplifier 232. The gate terminals of the sense amplifier precharge devices may receive a sense amplifier precharge signal, sapchx.

A write path of the read and write circuitry 230 may include write column select devices mpw0, mnw0, mpw1 and mnw1. Device mpw0 may be coupled between a write data node wrdatabb and the wbl, while device mpw1 may be coupled between a write data bar node wrdatab and the wblb. The write data node wrdatabb may receive a logic value that corresponds to the bit to be written, while the write data bar node wrdatab may receive the inverse of the logic value. For example, an inverter 236 may receive write data wrdata and generate the inverse of the logic value at the write data bar node wrdatab. Another inverter 238 may be coupled between the write data bar node wrdatab and the write data node wrdatabb to invert the logic value again (e.g., the bar bar value) to provide the write data node wrdatabb with the logic value.

Additionally, device wnw0 may be coupled between the write data node wrdatabb and the rwbl, and device mnw1 may be coupled between the write data bar node wrdatab and the rwblb. The gate terminals of the devices mnw0 and mnw1 may receive a write column select signal, wrcol, while the gate terminals of the devices mps0 and mpw1 may receive an inverse of the write column select signal (e.g., via inverter 240).

During idle and/or retention mode, the read and write bitlines (rwbl and rwblb) and inputs (sat and sac) of the sense amplifier 232 remain in a precharge condition (e.g., the bit line precharge devices mpbpch0/mpbpch1 and sense amplifier precharge devices mpspch0/mpspch1 are on responsive to the respective precharge signals). At the beginning of a read operation, the bitline precharge devices and sense amplifier precharge devices are turned off. One of the read and write wordlines (rwwl) is asserted (e.g., corresponding to one of the bitcells 100 in the array), which turns on the passgate transistors mnpg0 and mnpg1. One of rwbl or rwblb discharges based on the logic value stored by the bitcell 100, causing a voltage differential between the rwbl and rwblb.

The read column select devices mpr0 and mpr1 are turned on (e.g., responsive to read column select signal rdcolx), which transfers the differential voltage to the inputs of the sense amplifier 232. The sense amplifier 232 is enabled to evaluate the read and generate a read output, rdout. At the end of the read operation, the passgate transistors mnpg0 and mnpg1 are turned off (e.g., the rwwl signal is de-asserted) and the read column select devices mpr0 and mpr1 are turned off (e.g., responsive to the read column select signal). The precharge devices may be turned on to enter idle/retention mode.

Prior to a write operation, the bitline precharge devices (mpbpch0 and mpbpch1) are turned off (e.g., responsive to the precharge signal, blpchx). The inputs of the sense amplifier (sat and sac) may remain in precharge state (e.g., sense amplifier precharge devices may be on). The write column select signal (wrcol) turns on the write column select devices mpw0, mpw1, mnw0, and mnw1, which transfers the logic value of the bit to be written to the wbl and rwbl (via wrdatabb), and transfers the inverse of the logic value to the wblb and rwblb (via wrdatab). Subsequently, all of the passgate transistors (mnpg0, mnpg1, mppg0, and mppg1) in the bitcell 100 may be turned on to write the bit to the bitcell 100. For example, the rwwl signal may be logic high and the wwl signal may be logic low.

Accordingly, the write operation may be dual-ended, with a CMOS passgate (including both an NMOS and PMOS transistor) on each side of the bitcell. The write operation enables writing both logic 0 and logic 1 differentially, in contrast to traditional SRAM bitcells. Furthermore, the write operation may not require an additional write assist, and/or may provide significantly lower write Vmin than prior techniques (even with write assist).

Memory bitcells, such as SRAM bitcells, have three primary functionalities: retention (to hold the logic state stored in the bitcell), write (to update the logic state stored in the bitcell), and read (to read the stored value without disturbing the current state). A traditional SRAM cell includes a single passgate transistor on each side of the cell (coupled to the respective bit node and bit bar node). The passgate transistors are controlled by a wordline. When the wordline is asserted, the passgate transistors are turned on to perform the read or write operation.

During the write operation on the traditional SRAM cell, new content is written to the bitcell by overcoming the contention of the PMOS pull-up device through the passgate transistor with a strong write driver situated in a periphery circuit. The passgate transistors are sized with relatively higher drive strength than the pull-up transistors.

During the read operation on the traditional SRAM cell, the bitlines are precharged and passgate transistors are turned on, causing one of the bitlines to discharge from its precharged state based on the logic value stored by the bitcell. As the bitline is discharged, there is a bump of voltage potential at the corresponding bit node or bit bar node that holds a logic 0, which causes the voltage of the other of the bit node or bit bar node to drop below the supply voltage and may flip the state of the bitcell. To improve the read stability, the pass-gate transistors may be designed to have lower drive strength than the pull-down transistors, so that the state of the bitcell doesn't get destroyed (referred to as read disturb). Furthermore, a 1:2 ratio of the pull-up to pull-down devices skews the switching point of the cross-coupled inverters formed by the pull-up and pull-down devices. The read bump at the logic node that stores a logic 0 reduces the overdrive of the PMOS pull-up transistor that holds the logic 1. Thus, a weaker PMOS pull-up device increases the probability of cell stability failure.

However, manufacturing bitcell circuits with the transistor ratios to achieve these two conflicting requirements is challenging, e.g., in quantized fin-based FET (FinFet) and gate all-around FET (GAAFET) processes. Increased random process variation due to the smaller transistor dimensions in SRAM exacerbates the problem, driving the overall SRAM minimum operating voltage (Vmin) to be greater than the logic Vmin. To improve the read stability and writability, various additional techniques have been developed. For example, read assist techniques such as wordline underdrive, and write assist techniques such as wordline boost, transient voltage collapse of the bitcell voltage, P-shared or self-induced collapse of the bitcell voltage, and/or negative bitlines are used.

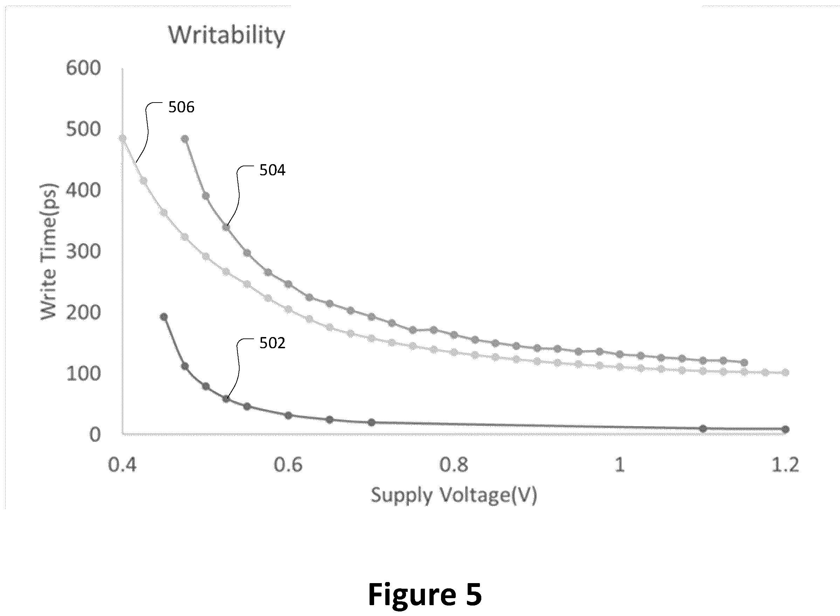

In contrast, the memory bitcells described herein may not require the conflicting size ratios for read stability and write stability. For example, the full complementary (with both PMOS and NMOS passgates) and dual-ended write operation may not have strict sizing requirements for the pull-up and pull-down transistors. Rather, the writability of the bitcell improves significantly since both logic 1 and logic 0 are written from both sides of the bitcell through PMOS and NMOS transistors. Figure 5 illustrates example simulation results showing a writability curve 502 of write time versus supply voltage for a balanced SRAM cell (e.g., the memory cell 100 of Figure 1) compared with a writability curve 504 for a legacy SRAM cell with write assist and a voltage-frequency (VF) curve 506 for logic circuitry.

In some embodiments of the memory cell described herein, the drive strength of the pull-down transistors may be greater than the drive strength of the pull-up transistors. However, the ratio may be less than 2:1, such as 3:2. The drive strength of the passgate transistors may be substantially the same as the pull-up transistors (e.g., subject to normal process variation) and less than the pull-down transistors. In other embodiments, the pull-up transistors and pull-down transistors of the memory bitcell described herein may have substantially the same drive strength.

In some embodiments, traditional column multiplexing may not be used with the memory cells described herein due to the increased writability of the memory cells. Accordingly, a local wordline driver (e.g., mini-decoder) may be included to provide a selective write operation for byte writability.

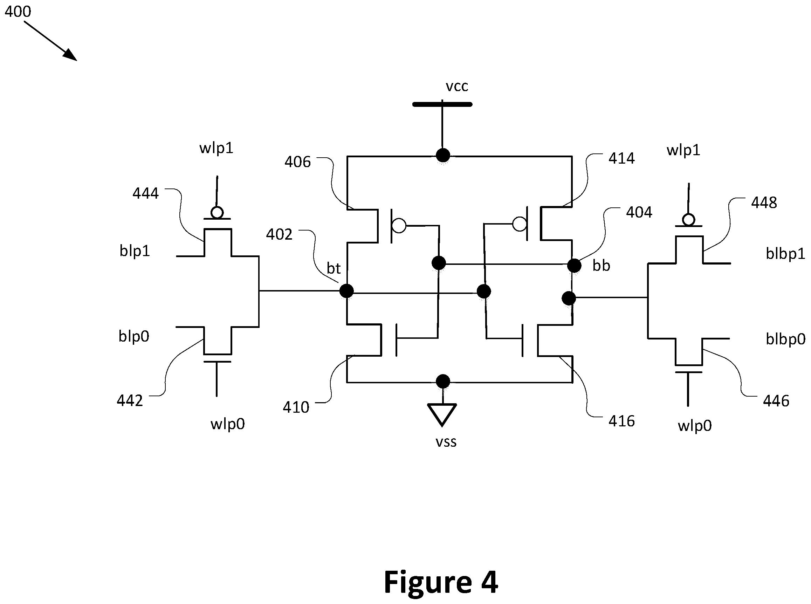

Figure 4 illustrates another memory cell 400 in accordance with various embodiments. The memory cell 400 is a dual-ported memory cell, such as an SRAM cell, that enables write and/or read operations from two different ports.

The memory cell 400 may include a same transistor layout as the memory cell 100. Accordingly, the memory cell 400 may include a balanced (equal) number of PMOS and NMOS transistors.

For example, the memory cell 400 includes pull-up transistors 406 and 414, and pull-down transistors 410 and 416 that may correspond to the respective pull-up and pull-down transistors of memory cell 100. The pull-up and pull-down transistors may form cross-coupled inverters to store a logic value at bit node 402 and an inverse of the logic value at bit bar node 404.

The memory cell 400 may further include a first passgate transistor 442, a second passgate transistor 444, a third passgate transistor 446, and a fourth passgate transistor 448. The first passgate transistor 442 may be coupled between the bit node 402 and a first bit line (blp0) for a first port, and its gate terminal may be coupled to a first wordline (wlp0) associated with the first port. The second passgate transistor 444 may be coupled between the bit node 402 and a second bit line (blp1) for a second port, and its gate terminal may be coupled to a second wordline (wlp1) associated with the second port. The third passgate transistor 446 may be coupled between the bit bar node 404 and a first bit line bar (blbp0), and its gate terminal may be coupled to the first wordline (wlp0). The fourth passgate transistor 448 may be coupled between the bit bar node 404 and a second bit line bar (blbp1), and its gate terminal may be coupled to the second wordline (wlp1).

In embodiments, the memory cell 400 may be written to or read from independently via the first or second port by asserting the corresponding first or second wordline.

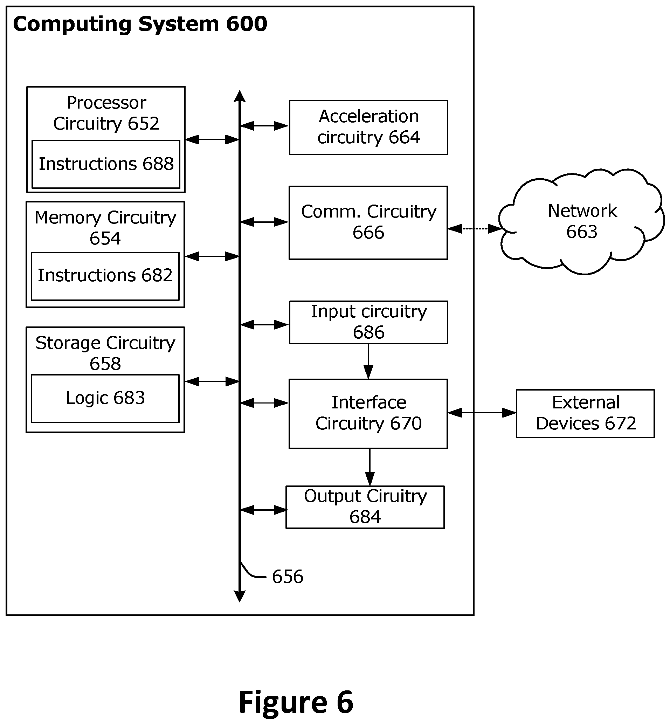

Figure 6 illustrates an example of components that may be present in a computing system 600 for implementing the techniques described herein. The computing system 600 may include any combinations of the hardware or logical components referenced herein. The components may be implemented as ICs, portions thereof, discrete electronic devices, or other modules, instruction sets, programmable logic or algorithms, hardware, hardware accelerators, software, firmware, or a combination thereof adapted in the computing system 600, or as components otherwise incorporated within a chassis of a larger system. For one embodiment, at least one processor 652 may be packaged together with computational logic 682 and configured to practice aspects of various example embodiments described herein to form a System in Package (SiP) or a System on Chip (SoC).

The system 600 includes processor circuitry in the form of one or more processors 652. The processor circuitry 652 includes circuitry such as, but not limited to one or more processor cores and one or more of cache memory, low drop-out voltage regulators (LDOs), interrupt controllers, serial interfaces such as SPI, I2C or universal programmable serial interface circuit, real time clock (RTC), timer-counters including interval and watchdog timers, general purpose I/O, memory card controllers such as secure digital/multi-media card (SD/MMC) or similar, interfaces, mobile industry processor interface (MIPI) interfaces and Joint Test Access Group (JTAG) test access ports. In some implementations, the processor circuitry 652 may include one or more hardware accelerators (e.g., same or similar to acceleration circuitry 664), which may be microprocessors, programmable processing devices (e.g., FPGA, ASIC, etc.), or the like. The one or more accelerators may include, for example, computer vision and/or deep learning accelerators. In some implementations, the processor circuitry 652 may include on-chip memory circuitry, which may include any suitable volatile and/or non-volatile memory, such as DRAM, SRAM, EPROM, EEPROM, Flash memory, solid-state memory, and/or any other type of memory device technology, such as those discussed herein

The processor circuitry 652 may include, for example, one or more processor cores (CPUs), application processors, GPUs, RISC processors, Acorn RISC Machine (ARM) processors, CISC processors, one or more DSPs, one or more FPGAs, one or more PLDs, one or more ASICs, one or more baseband processors, one or more radio-frequency integrated circuits (RFIC), one or more microprocessors or controllers, a multi-core processor, a multithreaded processor, an ultra-low voltage processor, an embedded processor, or any other known processing elements, or any suitable combination thereof. The processors (or cores) 652 may be coupled with or may include memory/storage and may be configured to execute instructions stored in the memory/storage to enable various applications or operating systems to run on the platform 600. The processors (or cores) 652 is configured to operate application software to provide a specific service to a user of the platform 600. In some embodiments, the processor(s) 652 may be a special-purpose processor(s)/controller(s) configured (or configurable) to operate according to the various embodiments herein.

As examples, the processor(s) 652 may include an Intel^{®} Architecture Core^{™} based processor such as an i3, an i5, an i7, an i9 based processor; an Intel^{®} microcontroller-based processor such as a Quark^{™}, an Atom^{™}, or other MCU-based processor; Pentium^{®} processor(s), Xeon^{®} processor(s), or another such processor available from Intel^{®} Corporation, Santa Clara, California. However, any number other processors may be used, such as one or more of Advanced Micro Devices (AMD) Zen^{®} Architecture such as Ryzen^{®} or EPYC^{®} processor(s), Accelerated Processing Units (APUs), MxGPUs, Epyc^{®} processor(s), or the like; A5-A12 and/or S1-S4 processor(s) from Apple^{®} Inc., Snapdragon^{™} or Centriq^{™} processor(s) from Qualcomm^{®} Technologies, Inc., Texas Instruments, Inc.^{®} Open Multimedia Applications Platform (OMAP)^{™} processor(s); a MIPS-based design from MIPS Technologies, Inc. such as MIPS Warrior M-class, Warrior I-class, and Warrior P-class processors; an ARM-based design licensed from ARM Holdings, Ltd., such as the ARM Cortex-A, Cortex-R, and Cortex-M family of processors; the ThunderX2^{®} provided by Cavium^{™}, Inc.; or the like. In some implementations, the processor(s) 652 may be a part of a system on a chip (SoC), System-in-Package (SiP), a multi-chip package (MCP), and/or the like, in which the processor(s) 652 and other components are formed into a single integrated circuit, or a single package, such as the Edison^{™} or Galileo^{™} SoC boards from Intel^{®} Corporation. Other examples of the processor(s) 652 are mentioned elsewhere in the present disclosure.

The system 600 may include or be coupled to acceleration circuitry 664, which may be embodied by one or more artificial intelligence (AI)/machine learning (ML) accelerators, a neural compute stick, neuromorphic hardware, an FPGA, an arrangement of GPUs, one or more SoCs (including programmable SoCs), one or more CPUs, one or more digital signal processors, dedicated ASICs (including programmable ASICs), PLDs such as complex (CPLDs) or high complexity PLDs (HCPLDs), and/or other forms of specialized processors or circuitry designed to accomplish one or more specialized tasks. These tasks may include AI/ML processing (e.g., including training, inferencing, and classification operations), visual data processing, network data processing, object detection, rule analysis, or the like. In FPGA-based implementations, the acceleration circuitry 664 may comprise logic blocks or logic fabric and other interconnected resources that may be programmed (configured) to perform various functions, such as the procedures, methods, functions, etc. of the various embodiments discussed herein. In such implementations, the acceleration circuitry 664 may also include memory cells (e.g., EPROM, EEPROM, flash memory, static memory (e.g., SRAM, anti-fuses, etc.) used to store logic blocks, logic fabric, data, etc. in LUTs and the like.

In some implementations, the processor circuitry 652 and/or acceleration circuitry 664 may include hardware elements specifically tailored for machine learning and/or artificial intelligence (AI) functionality. In these implementations, the processor circuitry 652 and/or acceleration circuitry 664 may be, or may include, an AI engine chip that can run many different kinds of AI instruction sets once loaded with the appropriate weightings and training code. Additionally or alternatively, the processor circuitry 652 and/or acceleration circuitry 664 may be, or may include, AI accelerator(s), which may be one or more of the aforementioned hardware accelerators designed for hardware acceleration of AI applications. As examples, these processor(s) or accelerators may be a cluster of artificial intelligence (AI) GPUs, tensor processing units (TPUs) developed by Google^{®} Inc., Real AI Processors (RAPs^{™}) provided by AlphaICs^{®}, Nervana^{™} Neural Network Processors (NNPs) provided by Intel^{®} Corp., Intel^{®} Movidius^{™} Myriad^{™} X Vision Processing Unit (VPU), NVIDIA^{®} PX^{™} based GPUs, the NM500 chip provided by General Vision^{®}, Hardware 3 provided by Tesla^{®}, Inc., an Epiphany^{™} based processor provided by Adapteva^{®}, or the like. In some embodiments, the processor circuitry 652 and/or acceleration circuitry 664 and/or hardware accelerator circuitry may be implemented as AI accelerating co-processor(s), such as the Hexagon 685 DSP provided by Qualcomm^{®}, the PowerVR 2NX Neural Net Accelerator (NNA) provided by Imagination Technologies Limited^{®}, the Neural Engine core within the Apple^{®} A11 or A12 Bionic SoC, the Neural Processing Unit (NPU) within the HiSilicon Kirin 470 provided by Huawei^{®}, and/or the like. In some hardware-based implementations, individual subsystems of system 600 may be operated by the respective AI accelerating co-processor(s), AI GPUs, TPUs, or hardware accelerators (e.g., FPGAs, ASICs, DSPs, SoCs, etc.), etc., that are configured with appropriate logic blocks, bit stream(s), etc. to perform their respective functions.

The system 600 also includes system memory 654. Any number of memory devices may be used to provide for a given amount of system memory. As examples, the memory 654 may be, or include, volatile memory such as random access memory (RAM), static RAM (SRAM), dynamic RAM (DRAM), synchronous DRAM (SDRAM), RAMBUS^{®} Dynamic Random Access Memory (RDRAM^{®}), and/or any other desired type of volatile memory device. Additionally or alternatively, the memory 654 may be, or include, non-volatile memory such as read-only memory (ROM), erasable programmable ROM (EPROM), electrically erasable programmable (EEPROM), flash memory, non-volatile RAM, ferroelectric RAM, phase-change memory (PCM), flash memory, and/or any other desired type of non-volatile memory device. Access to the memory 654 is controlled by a memory controller. The individual memory devices may be of any number of different package types such as single die package (SDP), dual die package (DDP) or quad die package (Q17P). Any number of other memory implementations may be used, such as dual inline memory modules (DIMMs) of different varieties including but not limited to microDIMMs or MiniDIMMs.

Storage circuitry 658 provides persistent storage of information such as data, applications, operating systems and so forth. In an example, the storage 658 may be implemented via a solid-state disk drive (SSDD) and/or high-speed electrically erasable memory (commonly referred to as "flash memory"). Other devices that may be used for the storage 658 include flash memory cards, such as SD cards, microSD cards, XD picture cards, and the like, and USB flash drives. In an example, the memory device may be or may include memory devices that use chalcogenide glass, multi-threshold level NAND flash memory, NOR flash memory, single or multi-level Phase Change Memory (PCM), a resistive memory, nanowire memory, ferroelectric transistor random access memory (FeTRAM), anti-ferroelectric memory, magnetoresistive random access memory (MRAM) memory that incorporates memristor technology, phase change RAM (PRAM), resistive memory including the metal oxide base, the oxygen vacancy base and the conductive bridge Random Access Memory (CB-RAM), or spin transfer torque (STT)-MRAM, a spintronic magnetic junction memory based device, a magnetic tunneling junction (MTJ) based device, a Domain Wall (DW) and Spin Orbit Transfer (SOT) based device, a thyristor based memory device, a hard disk drive (HDD), micro HDD, of a combination thereof, and/or any other memory. The memory circuitry 654 and/or storage circuitry 658 may also incorporate three-dimensional (3D) cross-point (XPOINT) memories from Intel^{®} and Micron^{®}.

The memory circuitry 654 and/or storage circuitry 658 is/are configured to store computational logic 683 in the form of software, firmware, microcode, or hardware-level instructions to implement the techniques described herein. The computational logic 683 may be employed to store working copies and/or permanent copies of programming instructions, or data to create the programming instructions, for the operation of various components of system 600 (e.g., drivers, libraries, application programming interfaces (APIs), etc.), an operating system of system 600, one or more applications, and/or for carrying out the embodiments discussed herein. The computational logic 683 may be stored or loaded into memory circuitry 654 as instructions 682, or data to create the instructions 682, which are then accessed for execution by the processor circuitry 652 to carry out the functions described herein. The processor circuitry 652 and/or the acceleration circuitry 664 accesses the memory circuitry 654 and/or the storage circuitry 658 over the interconnect (IX) 656. The instructions 682 direct the processor circuitry 652 to perform a specific sequence or flow of actions, for example, as described with respect to flowchart(s) and block diagram(s) of operations and functionality depicted previously. The various elements may be implemented by assembler instructions supported by processor circuitry 652 or high-level languages that may be compiled into instructions 681, or data to create the instructions 681, to be executed by the processor circuitry 652. The permanent copy of the programming instructions may be placed into persistent storage devices of storage circuitry 658 in the factory or in the field through, for example, a distribution medium (not shown), through a communication interface (e.g., from a distribution server (not shown)), over-the-air (OTA), or any combination thereof.

The IX 656 couples the processor 652 to communication circuitry 666 for communications with other devices, such as a remote server (not shown) and the like. The communication circuitry 666 is a hardware element, or collection of hardware elements, used to communicate over one or more networks 663 and/or with other devices. In one example, communication circuitry 666 is, or includes, transceiver circuitry configured to enable wireless communications using any number of frequencies and protocols such as, for example, the Institute of Electrical and Electronics Engineers (IEEE) 802.11 (and/or variants thereof), IEEE 802.7.4, Bluetooth^{®} and/or Bluetooth^{®} low energy (BLE), ZigBee^{®}, LoRaWAN^{™} (Long Range Wide Area Network), a cellular protocol such as 3GPP LTE and/or Fifth Generation (5G)/New Radio (NR), and/or the like. Additionally or alternatively, communication circuitry 666 is, or includes, one or more network interface controllers (NICs) to enable wired communication using, for example, an Ethernet connection, Controller Area Network (CAN), Local Interconnect Network (LIN), DeviceNet, ControlNet, Data Highway+, or PROFINET, among many others.

The IX 656 also couples the processor 652 to interface circuitry 670 that is used to connect system 600 with one or more external devices 672. The external devices 672 may include, for example, sensors, actuators, positioning circuitry (e.g., global navigation satellite system (GNSS)/Global Positioning System (GPS) circuitry), client devices, servers, network appliances (e.g., switches, hubs, routers, etc.), integrated photonics devices (e.g., optical neural network (ONN) integrated circuit (IC) and/or the like), and/or other like devices.

In some optional examples, various input/output (I/O) devices may be present within or connected to, the system 600, which are referred to as input circuitry 686 and output circuitry 684 in Figure 6. The input circuitry 686 and output circuitry 684 include one or more user interfaces designed to enable user interaction with the system 600 and/or peripheral component interfaces designed to enable peripheral component interaction with the system 600. Input circuitry 686 may include any physical or virtual means for accepting an input including, inter alia, one or more physical or virtual buttons (e.g., a reset button), a physical keyboard, keypad, mouse, touchpad, touchscreen, microphones, scanner, headset, and/or the like. The output circuitry 684 may be included to show information or otherwise convey information, such as sensor readings, actuator position(s), or other like information. Data and/or graphics may be displayed on one or more user interface components of the output circuitry 684. Output circuitry 684 may include any number and/or combinations of audio or visual display, including, inter alia, one or more simple visual outputs/indicators (e.g., binary status indicators (e.g., light emitting diodes (LEDs)) and multi-character visual outputs, or more complex outputs such as display devices or touchscreens (e.g., Liquid Crystal Displays (LCD), LED displays, quantum dot displays, projectors, etc.), with the output of characters, graphics, multimedia objects, and the like being generated or produced from the operation of the system 600. The output circuitry 684 may also include speakers and/or other audio emitting devices, printer(s), and/or the like. Additionally or alternatively, sensor(s) may be used as the input circuitry 684 (e.g., an image capture device, motion capture device, or the like) and one or more actuators may be used as the output device circuitry 684 (e.g., an actuator to provide haptic feedback or the like). Peripheral component interfaces may include, but are not limited to, a non-volatile memory port, a USB port, an audio jack, a power supply interface, etc. In some embodiments, a display or console hardware, in the context of the present system, may be used to provide output and receive input of an edge computing system; to manage components or services of an edge computing system; identify a state of an edge computing component or service; or to conduct any other number of management or administration functions or service use cases.

The components of the system 600 may communicate over the IX 656. The IX 656 may include any number of technologies, including ISA, extended ISA, I2C, SPI, point-to-point interfaces, power management bus (PMBus), PCI, PCIe, PCIx, Intel^{®} UPI, Intel^{®} Accelerator Link, Intel^{®} CXL, CAPI, OpenCAPI, Intel^{®} QPI, UPI, Intel^{®} OPA IX, RapidIO^{™} system IXs, CCIX, Gen-Z Consortium IXs, a HyperTransport interconnect, NVLink provided by NVIDIA^{®}, a Time-Trigger Protocol (TTP) system, a FlexRay system, PROFIBUS, and/or any number of other IX technologies. The IX 656 may be a proprietary bus, for example, used in a SoC based system.

The number, capability, and/or capacity of the elements of system 600 may vary, depending on whether computing system 600 is used as a stationary computing device (e.g., a server computer in a data center, a workstation, a desktop computer, etc.) or a mobile computing device (e.g., a smartphone, tablet computing device, laptop computer, game console, IoT device, etc.). In various implementations, the computing device system 600 may comprise one or more components of a data center, a desktop computer, a workstation, a laptop, a smartphone, a tablet, a digital camera, a smart appliance, a smart home hub, a network appliance, and/or any other device/system that processes data.

### Examples

Some non-limiting examples of various embodiments are provided below.

Example 1 is a memory circuit comprising: a bit node to store a logic value of a bit; a first passgate transistor with a source or drain terminal coupled to the bit node, wherein the first passgate transistor is a p-type metal-oxide-semiconductor (PMOS) transistor; and a second passgate transistor with a source or drain terminal coupled to the bit node, wherein the second passgate transistor is an n-type metal-oxide-semiconductor (NMOS) transistor, and wherein both the first and second passgate transistors are turned on for a write operation to write the logic value to the bit node.

Example 2 is the memory circuit of example 1, wherein the source or drain terminals of the first and second passgate transistors are first source or drain terminals, and wherein: a second source or drain terminal of the first passgate transistor is coupled to a write bit line; a gate terminal of the first passgate transistor is coupled to a write word line; a second source or drain terminal of the second passgate transistor is coupled to a read and write bit line; and a gate terminal of the second passgate transistor is coupled to a read and write word line.

Example 3 is the memory circuit of example 1, wherein the source or drain terminals of the first and second passgate transistors are first source or drain terminals, and wherein: a second source or drain terminal of the first passgate transistor is coupled to a read and write bit line; a gate terminal of the first passgate transistor is coupled to a read and write word line; a second source or drain terminal of the second passgate transistor is coupled to a write bit line; and a gate terminal of the second passgate transistor is coupled to a write word line.

Example 4 is the memory circuit of any of examples 1-3, wherein the bit node, first passgate transistor, and second passgate transistor are included in a bitcell that has equal numbers of PMOS transistors and NMOS transistors.

Example 5 is the memory circuit of any of examples 1-4, wherein one of the first or second passgate transistor is turned on for a read operation to read the logic value.

Example 6 is the memory circuit of any of examples 1-5, further comprising: a bit bar node to store an inverse of the logic value; a third passgate transistor with a source or drain terminal coupled to the bit bar node, wherein the third passgate transistor is a PMOS transistor; and a fourth passgate transistor with a source or drain terminal coupled to the bit bar node, wherein the fourth passgate transistor is an NMOS transistor, and wherein the third and fourth passgate transistors are also turned on for the write operation.

Example 7 is the memory circuit of example 6, further comprising: a first pull-up transistor coupled between the bit node and a Vcc rail and having a gate terminal coupled to the bit bar node; a first pull-down transistor coupled between the bit node and a Vss rail and having a gate terminal coupled to the bit bar node; a second pull-up transistor coupled between the bit bar node and the Vcc rail and having a gate terminal coupled to the bit node; and a second pull-down transistor coupled between the bit bar node and the Vss rail and having a gate terminal coupled to the bit node; wherein the first and second pull-up transistors are PMOS transistors and the first and second pull-down transistors are NMOS transistors.

Example 8 is the memory circuit of example 7, wherein a drive strength of the first and second passgate transistors is substantially the same as the first and second pull-up transistors and less than the first and second pull-down transistors.

Example 9 is the memory circuit of any of examples 1-8, wherein the memory circuit is coupled to one or more processor cores in an integrated circuit package.

Example 10 is a dual-ported memory circuit comprising: a bit node to store a logic value of a bit; a first passgate transistor with a first source or drain terminal coupled to the bit node, a second source or drain terminal coupled to a first bitline associated with a first port, and a gate terminal coupled to a first word line, wherein the first passgate transistor is a p-type metal-oxide-semiconductor (PMOS) transistor; and a second passgate transistor with a first source or drain terminal coupled to the bit node, a second source or drain terminal coupled to a second bitline associated with a second port, and a gate terminal coupled to a second word line, wherein the second passgate transistor is a n-type metal-oxide-semiconductor (NMOS) transistor.

Example 11 is the dual-ported memory circuit of example 10, further comprising: a bit bar node to store an inverse of the logic value; a third passgate transistor with a first source or drain terminal coupled to the bit bar node, a second source or drain terminal coupled to a first bitline bar, and a gate terminal coupled to the first word line, wherein the third passgate transistor is a PMOS transistor; and a fourth passgate transistor with a first source or drain terminal coupled to the bit bar node, a second source or drain terminal coupled to a second bitline bar, and a gate terminal coupled to the second word line, wherein the fourth passgate transistor is an NMOS transistor.

Example 12 is the dual-ported memory circuit of example 11, further comprising: a first pull-up transistor coupled between the bit node and a Vcc rail and having a gate terminal coupled to the bit bar node; a first pull-down transistor coupled between the bit node and a Vss rail and having a gate terminal coupled to the bit bar node; a second pull-up transistor coupled between the bit bar node and the Vcc rail and having a gate terminal coupled to the bit node; and a second pull-down transistor coupled between the bit bar node and the Vss rail and having a gate terminal coupled to the bit node; wherein the first and second pull-up transistors are PMOS transistors and the first and second pull-down transistors are NMOS transistors.

Example 13 is the dual-ported memory circuit of example 11 or 12, wherein the first and third passgate transistors are turned on for a first read operation and a first write operation associated with the first port, and wherein the second and fourth passgate transistors are turned on for a second read operation and a second write operation associated with the second port.

Example 14 is a system comprising: processor circuitry that includes one or more processor cores; and memory circuitry coupled to the processor circuitry, wherein the memory circuitry includes an array of bitcells. An individual bitcell of the array includes: a bit node to store a logic value of a bit; a first passgate transistor with a first source or drain terminal coupled to the bit node, a second source or drain terminal coupled to a write bit line (wbl), and a gate terminal coupled to a write word line (wwl); and a second passgate transistor with a first source or drain terminal coupled to the bit node, a second source or drain terminal coupled to a read and write bit line (rwbl), and a gate terminal coupled to a read and write word line (rwwl).

Example 15 is the system of example 14, wherein: the first passgate transistor is a p-type metal-oxide-semiconductor (PMOS) transistor and the second passgate transistor is an n-type metal-oxide-semiconductor (NMOS) transistor; or the first passgate transistor is an NMOS transistor and the second passgate transistor is a PMOS transistor.

Example 16 is the system of example 15, wherein the individual bitcells have equal numbers of PMOS transistors and NMOS transistors.

Example 17 is the system of any of examples 14-16, wherein both the first and second passgate transistors are turned on to write the logic value to the bit node.

Example 18 is the system of any of examples 14-17, wherein the second passgate transistor is to turn on responsive to the read and write word line for both a read operation and a write operation.

Example 19 is the system of any of examples 14-18, wherein the individual bitcell further includes: a bit bar node to store an inverse of the logic value; a third passgate transistor with a first source or drain terminal coupled to the bit bar node, a second source or drain terminal coupled to a write bit line bar (wblb), and a gate terminal coupled to the write word line (wwl); and a fourth passgate transistor with a first source or drain terminal coupled to the bit bar node, a second source or drain terminal coupled to a read and write bit line bar (rwblb), and a gate terminal coupled to the read and write word line (rwwl).

Example 20 is the system of any of examples 14-18, wherein the individual bitcell further includes: a bit bar node to store an inverse of the logic value; a first pull-up transistor coupled between the bit node and a Vcc rail and having a gate terminal coupled to the bit bar node; a first pull-down transistor coupled between the bit node and a Vss rail and having a gate terminal coupled to the bit bar node; a second pull-up transistor coupled between the bit bar node and the Vcc rail and having a gate terminal coupled to the bit node; and a second pull-down transistor coupled between the bit bar node and the Vss rail and having a gate terminal coupled to the bit node.

Example 21 is the system of example 20, wherein a drive strength of the first and second passgate transistors is the same as the first and second pull-up transistors and less than the first and second pull-down transistors.

In the preceding detailed description, reference is made to the accompanying drawings that form a part hereof wherein like numerals designate like parts throughout, and in which is shown by way of illustration embodiments that may be practiced. It is to be understood that other embodiments may be utilized and structural or logical changes may be made without departing from the scope of the present disclosure. Therefore, the following detailed description is not to be taken in a limiting sense, and the scope of embodiments is defined by the appended claims and their equivalents.

Various operations may be described as multiple discrete actions or operations in turn, in a manner that is most helpful in understanding the claimed subject matter. However, the order of description should not be construed as to imply that these operations are necessarily order dependent. In particular, these operations may not be performed in the order of presentation. Operations described may be performed in a different order than the described embodiment. Various additional operations may be performed and/or described operations may be omitted in additional embodiments.

The terms "substantially," "close," "approximately," "near," and "about," generally refer to being within +/- 10% of a target value. Unless otherwise specified the use of the ordinal adjectives "first," "second," and "third," etc., to describe a common object, merely indicate that different instances of like objects are being referred to, and are not intended to imply that the objects so described must be in a given sequence, either temporally, spatially, in ranking or in any other manner.

For the purposes of the present disclosure, the phrases "A and/or B" and "A or B" mean (A), (B), or (A and B). For the purposes of the present disclosure, the phrase "A, B, and/or C" means (A), (B), (C), (A and B), (A and C), (B and C), or (A, B, and C).

The description may use the phrases "in an embodiment," or "in embodiments," which may each refer to one or more of the same or different embodiments. Furthermore, the terms "comprising," "including," "having," and the like, as used with respect to embodiments of the present disclosure, are synonymous.

As used herein, the term "circuitry" may refer to, be part of, or include an Application Specific Integrated Circuit (ASIC), an electronic circuit, a processor (shared, dedicated, or group), a combinational logic circuit, and/or other suitable hardware components that provide the described functionality. As used herein, "computer-implemented method" may refer to any method executed by one or more processors, a computer system having one or more processors, a mobile device such as a smartphone (which may include one or more processors), a tablet, a laptop computer, a set-top box, a gaming console, and so forth.

Although certain embodiments have been illustrated and described herein for purposes of description, this application is intended to cover any adaptations or variations of the embodiments discussed herein. Therefore, it is manifestly intended that embodiments described herein be limited only by the claims.

Where the disclosure recites "a" or "a first" element or the equivalent thereof, such disclosure includes one or more such elements, neither requiring nor excluding two or more such elements. Further, ordinal indicators (e.g., first, second, or third) for identified elements are used to distinguish between the elements, and do not indicate or imply a required or limited number of such elements, nor do they indicate a particular position or order of such elements unless otherwise specifically stated.

## Claims

1. A memory circuit comprising:
a bit node to store a logic value of a bit;
a first passgate transistor with a source or drain terminal coupled to the bit node, wherein the first passgate transistor is a p-type metal-oxide-semiconductor (PMOS) transistor; and
a second passgate transistor with a source or drain terminal coupled to the bit node, wherein the second passgate transistor is an n-type metal-oxide-semiconductor (NMOS) transistor, and wherein both the first and second passgate transistors are turned on for a write operation to write the logic value to the bit node.

2. The memory circuit of claim 1, wherein the source or drain terminals of the first and second passgate transistors are first source or drain terminals, and wherein:
a second source or drain terminal of the first passgate transistor is coupled to a write bit line;
a gate terminal of the first passgate transistor is coupled to a write word line;
a second source or drain terminal of the second passgate transistor is coupled to a read and write bit line; and
a gate terminal of the second passgate transistor is coupled to a read and write word line.

3. The memory circuit of claim 1, wherein the source or drain terminals of the first and second passgate transistors are first source or drain terminals, and wherein:
a second source or drain terminal of the first passgate transistor is coupled to a read and write bit line;
a gate terminal of the first passgate transistor is coupled to a read and write word line;
a second source or drain terminal of the second passgate transistor is coupled to a write bit line; and
a gate terminal of the second passgate transistor is coupled to a write word line.

4. The memory circuit of any one of claims 1-3, wherein the bit node, first passgate transistor, and second passgate transistor are included in a bitcell that has equal numbers of PMOS transistors and NMOS transistors.

5. The memory circuit of any one of claims 1-4, wherein one of the first or second passgate transistor is turned on for a read operation to read the logic value.

6. The memory circuit of any one of claims 1-5, further comprising:
a bit bar node to store an inverse of the logic value;
a third passgate transistor with a source or drain terminal coupled to the bit bar node, wherein the third passgate transistor is a PMOS transistor; and
a fourth passgate transistor with a source or drain terminal coupled to the bit bar node, wherein the fourth passgate transistor is an NMOS transistor, and wherein the third and fourth passgate transistors are also turned on for the write operation.

7. The memory circuit of claim 6, further comprising:
a first pull-up transistor coupled between the bit node and a Vcc rail and having a gate terminal coupled to the bit bar node;
a first pull-down transistor coupled between the bit node and a Vss rail and having a gate terminal coupled to the bit bar node;
a second pull-up transistor coupled between the bit bar node and the Vcc rail and having a gate terminal coupled to the bit node; and
a second pull-down transistor coupled between the bit bar node and the Vss rail and having a gate terminal coupled to the bit node;
wherein the first and second pull-up transistors are PMOS transistors and the first and second pull-down transistors are NMOS transistors.

8. The memory circuit of claim 7, wherein a drive strength of the first and second passgate transistors is substantially the same as the first and second pull-up transistors and less than the first and second pull-down transistors.

9. A method comprising:
coupling memory circuitry to processor circuitry; and
providing the memory circuitry with an array of bitcells, wherein an individual bitcell of the array includes:
a bit node to store a logic value of a bit;
a first passgate transistor with a first source or drain terminal coupled to the bit node, a second source or drain terminal coupled to a write bit line, and a gate terminal coupled to a write word line; and
a second passgate transistor with a first source or drain terminal coupled to the bit node, a second source or drain terminal coupled to a read and write bit line, and a gate terminal coupled to a read and write word line.

10. A non-transitory machine-readable storage including machine-readable instructions that, when executed, cause a processor or other circuit or computing device to implement the method of claim 9.

11. An apparatus comprising means to perform the method of claim 10.
